# EUROPEAN PATENT SPECIFICATION

(11) **EP 0 740 376 B1**
(45) Date of publication and mention of the grant of the patent: **03.02.1999**
(21) Application number: 96102542.6
(22) Date of filing: 20.02.1996
(51) Int. Cl.: H01S 3/085, H01S 3/19, H01S 3/025, H01L 33/00

(54) **Semiconductor laser diode and manufacturing method for the same**
Halbleiterlaserdiode und deren Herstellungsverfahren
Diode laser à semi-conducteur et méthode de fabrication

(30) Priority: 28.04.1995 JP 105763/95
(43) Date of publication of application: 30.10.1996
(73) Proprietor: MITSUBISHI DENKI KABUSHIKI KAISHA, Tokyo 100 (JP)
(72) Inventor: Hayafuji, Norio, c/o Mitsubishi Denki K.K., 1 Mizuhara 4-chome, Itami-shi, Hyogo 664 (JP); Kawazu, Zempei, c/o Mitsubishi Denki K.K., 1 Mizuhara 4-chome, Itami-shi, Hyogo 664 (JP)
(74) Representative: Winter, Brandl, Fürniss, Hübner, Röss, Kaiser, Polte, Kindermann Partnerschaft

(56) References cited:
- EP-A- 0 488 510
- US-A- 5 038 356
- US-A- 5 146 465
- PATENT ABSTRACTS OF JAPAN vol. 014, no. 433 (E-0979), 17 September 1990 & JP-A-02 168689 (MITSUBISHI ELECTRIC CORP), 28 June 1990,
- PATENT ABSTRACTS OF JAPAN vol. 007, no. 115 (E-176), 19 May 1983 & JP-A-58 033888 (NIPPON DENSHIN DENWA KOSHA), 28 February 1983,
- PATENT ABSTRACTS OF JAPAN vol. 012, no. 402 (E-673), 25 October 1988 & JP-A-63 142861 (MATSUSHITA ELECTRIC IND CO LTD), 15 June 1988,

## Description

### FIELD OF THE INVENTION

This invention relates to a semiconductor laser diode of a short-wavelength light ranging from ultraviolet to green which is composed of a compound semiconductor, and a manufacturing method for the same.

### DESCRIPTION OF THE RELATED ART

To this day, the progress in the epitaxial growth technique for growing III-V group nitride on a sapphire substrate has achieved the commercialization of a light-emitting diode which emits blue light and which employs a III-V group compound semiconductor material. For example, on pages 44 to 55 of October issue, 1994 of "Nikkei Science Journal", discloses a light-emitting diode which has a GaInN/AlGaN double-hetero structure formed on a sapphire substrate by the metal-organic chemical vapor deposition technique (MOCVD technique). Applying the GaN type blue emission material to the structure of a typical laser diode allows a semiconductor laser diode of short-wavelength light to be obtained.

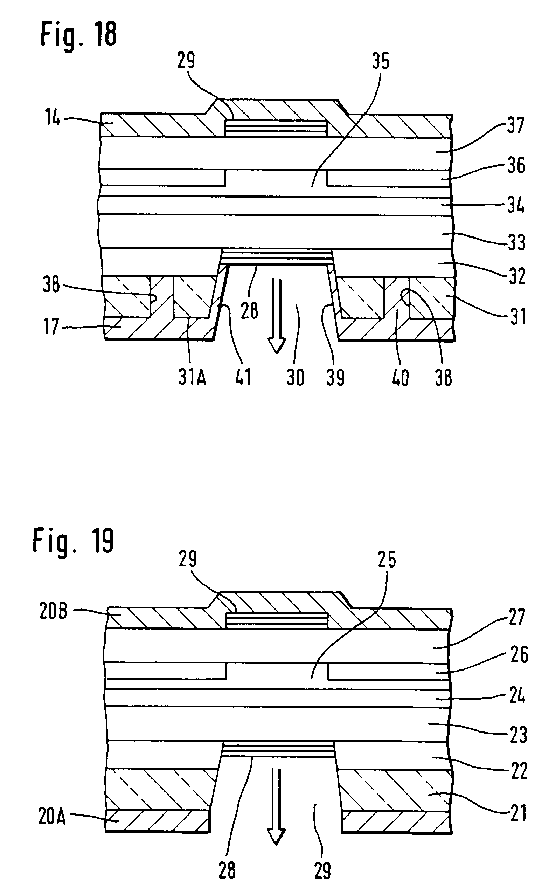

For instance, Fig. 19 is a cross-sectional view illustrative of the structure of a GaAs type plane-emission laser diode which is conventionally known. A similar laser diode is disclosed in US-A-5 038 356.

The laser diode shown in Fig. 19, is constructed by an nGaAs buffer layer 22, an nAlGaAs cladding layer 23, an undoped GaAs active layer 24, a pAlGaAs cladding layer 25, an nGaAs blocking layer 26, and a pGaAs contact layer 27 which are deposited on an nGaAs substrate 21 in the order in which they are listed. A region where a laser beam is oscillated is constructed by deposited layers which include the nAlGaAs cladding layer 23, the undoped GaAs active layer 24, the pAlGaAs cladding layer 25, and the pGaAs contact layer 27. A laser resonator is formed by sandwiched between a front reflecting film 28 attached to the nAlGaAs cladding layer 23 and a rear reflecting film 29 attached to the pGaAs contact layer 27. A n electrode 20A is formed on the surface of the nGaAs substrate 21 and a p electrode 20B is formed on the surface of the pGaAs contact layer 27.

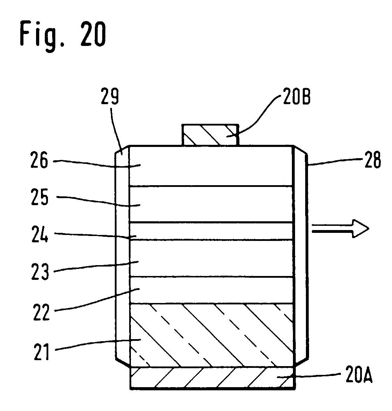

A laser beam is emitted through an opening 30 which exposes the front reflecting film 28 to the nGaAs substrate 21 side. Fig. 20 is a cross-sectional view illustrative of the structure of a conventionally known end surface emission type laser diode.

The structure shown includes the nGaAs substrate 21, the nGaAs buffer layer 22, the nAlGaAs cladding layer 23, the undoped GaAs active layer 24, the pAlGaAs cladding layer 25, and the pGaAs contact layer 26 which are deposited in the order in which they are listed. In this structure of deposition, the front reflecting film 28 and the rear reflecting film 29 are formed on cleaved surfaces so that they face each other. The n electrode is formed on the surface of the nGaAs substrate 21 and the p electrode is formed on the surface of the pGaAs contact layer 26. Light is amplified between the reflecting films 28 and 29 in the active layer 24 by resonance, then a laser beam is emitted from the front reflecting film 28.

In the laser diode structures shown in Fig. 19 and Fig. 20, the double-hetero structure, wherein sapphire is used for the substrate and the GaN material is used in place of the GaAs material, and the active layer is placed between the cladding layers, makes it possible to obtain a semiconductor laser diode having short-wavelength light which ranges from ultraviolet to green by placing the undoped GaInN layer between the n-type and p-type AlGaN layers.

In the semiconductor laser diodes employing GaN materials, the progress in the technique for growing the GaN semiconductor crystal on a sapphire substrate has brought about a dramatic progress in material quality. With the device structures shown in Fig. 19 and Fig. 20, however, it is still difficult to achieve a semiconductor laser diode having short-wavelength light simply by replacing the materials with the ones described above.

When the above-mentioned blue emission material is applied to the structure illustrated in Fig. 19, sapphire is used for the substrate. Sapphire is, however, a insulation material and simply producing the n electrode on the sapphire substrate cannot provide an electrical path to the double-hetero structure for oscillating laser beams, thus presenting a problem in that laser oscillation cannot be performed.

There is also a problem in the process. The layers 22 to 26 are deposited on the substrate 21, then the opening up to the nAlGaAs cladding layer 23 is formed. Such processing as etching is extremely difficult on the sapphire substrate and there are cases where the opening undesirably extends more deeply than necessary to, for example, the active layer 24 and the cladding layer 25, resulting in a low yield.

Furthermore, when the above-mentioned blue emission material is applied to the structure shown in Fig. 20, the sapphire and GaN material are hard to cleave, preventing sufficiently large cleaved surfaces from being obtained for oscillating a laser beam. Thus, it is impossible to realize the end surface emission type semiconductor laser diode.

### SUMMARY OF THE INVENTION

This invention is made to solve the above-described problems. It is an object of the invention to provide a high-performance, plane emission type semiconductor laser diode and a manufacturing method for the same.

It is another object of the invention to obtain the high-performance semiconductor laser diode which emits short-wavelength light, equipped with the first contact layer of the first conductive type which is embedded in the substrate in such a manner that it has an exposed surface on the main surface side of the insulation substrate, and thus allowed the electrode to be electrically connected to the aforesaid exposed surface.

It is a further object of the invention to obtain the high-performance semiconductor laser diode which emits short-wavelength light, equipped with the exposed surface in the first contact layer provides a plane which is continuous from and flush with the main surface of the substrate, whereby the electrode on the substrate can be easily and securely connected to the first contact layer continuously from the end sides thereof.

It is yet another object of the invention to obtain the high-performance semiconductor laser diode which emits short-wavelength light, equipped with the exposed surface in the first contact layer, which is configured to provide a plane, which continues from the end sides of the main surface of the substrate to the first cladding layer, whereby the electrode on the substrate can be connected to the first contact layer continuously from the end sides thereof.

It is yet another object of the invention to obtain the high-performance semiconductor laser diode which emits short-wavelength light, equipped with the side surfaces of the semiconductor layer, which are perpendicular to the depositing direction, are covered with the substrate, whereby the currents can be strangulated in other regions than the semiconductor layer region.

It is a further object of the invention to obtain the high-performance semiconductor laser diode which emits short-wavelength light, equipped with the main surface of the substrate having a hole through which a part of the first contact layer is exposed, and the electrode connected to the first contact layer which is exposed through the hole, whereby the electrode formed on the main surface of the substrate is electrically connected to the first contact layer.

These objects are solved with a laser diode in accordance with claims 1 and 5 and with a manufacturing method according to claim 10.

A semiconductor laser diode according to claim 1 comprises: a insulation substrate; a first contact layer consisting of a first conductive type semiconductor, which is embedded in the substrate, so that it has an exposed surface on a main surface of the substrate; a semiconductor layer constituting a first cladding layer consisted of the first conductive type semiconductor, an active layer, a second cladding layer consisted of a second conductive type semiconductor, and a second contact layer consisted of the second conductive type semiconductor, which are laminated in the order in which they are listed, the first cladding layer being connected with the first contact layer; a hole provided in the exposed surface of the first contact layer so that the first cladding layer is exposed on the main surface side of the substrate; a first reflector formed on the surface of the first cladding layer in the hole; a second reflector formed on the second contact layer in the semiconductor layer so that it faces against the first reflector; and an electrode which is formed on the main surface of the substrate so that it is connected to the exposed surface of the first contact layer.

A semiconductor laser diode according to claim 5 comprises: a insulation substrate which has a hole in a main surface thereof; a first contact layer consisted of the first conductive type semiconductor formed on the substrate; a semiconductor layer constituting of a first cladding layer consisted of the first conductive type semiconductor, an active layer, a second cladding layer consisted of the second conductive type semiconductor, and a second contact layer consisted of the second conductive semiconductor, which are laminated in the order in which they are listed, the first cladding layer forming the bottom surface of the hole in the substrate so that it is connected with the first contact layer; a first reflector formed on the first cladding layer which provides the bottom surface of the hole; a second reflector which is formed on the second contact layer in the semiconductor layer in such a manner that it faces against the first reflector; and an electrode formed on the main surface of the substrate; characterized in that the main surface of the substrate having a hole which exposes a part of the first contact layer and the electrode being configured so that it is connected to the first contact layer which is exposed through the hole.

A manufacturing method for a semiconductor laser diode according to claim 10 comprises: a first step for embedding a first semiconductor layer consisted of a first conductive type in a hole which is formed in a main surface of a insulation substrate; a second step for laminating a second semiconductor layer consisted of the first conductive type which provides a cladding layer, a third semiconductor layer which provides an active layer, and a fourth semiconductor layer consisted of the second conductive type which provides a cladding layer, in the order in which they are listed; a third step for lapping the rear surface of the substrate until said first semiconductor layer is exposed; and a fourth step for forming a hole, through which the second semiconductor layer is exposed, in a surface of the first semiconductor layer exposed on the rear surface of the substrate.

Other objects and advantages of this invention will become apparent from the detailed description given hereinafter. It should be understood, however, that the detailed description and specific embodiment are given(provided) by way of illustration only since various changes and modifications within the spirit and scope of the invention will become apparent to the those skilled in the art from this detailed description.

### BRIEF DESCRIPTION OF THE DRAWINGS

Fig. 1 is a cross-sectional view illustrating the structure of the semiconductor laser diode in a first embodiment of the invention.

Figs. 2 to 13 show cross-sectional views illustrating Steps 1 to 12 in the manufacture of the semiconductor laser diode shown in Fig. 1.

Fig. 14 is a perspective view illustrating an integrated laser diode which employs the semiconductor laser diode shown in Fig. 1.

Fig. 15 is a cross-sectional view illustrating the structure of the semiconductor laser diode shown in a second embodiment of the invention.

Fig. 16 is a cross-sectional view illustrating the structure of the semiconductor laser diode shown in a third embodiment of the invention.

Fig. 17 is a cross-sectional view illustrating the manufacturing process for the semiconductor laser diode shown in Fig. 16.

Fig. 18 is a cross-sectional view illustrating the structure of the semiconductor laser diode shown in the fourth embodiment of the invention.

Fig. 19 is a cross-sectional view illustrating the structure of an example of a plane-emission type semiconductor laser diode according to a prior art.

Fig. 20 is a cross-sectional view illustrating the structure of an example of an end-surface-emission type semiconductor laser diode according to a prior art.

In all figures, the same and the substantially same elements are the same reference numbers.

### DESCRIPTION OF PREFERRED EMBODIMENTS

### First Embodiment:

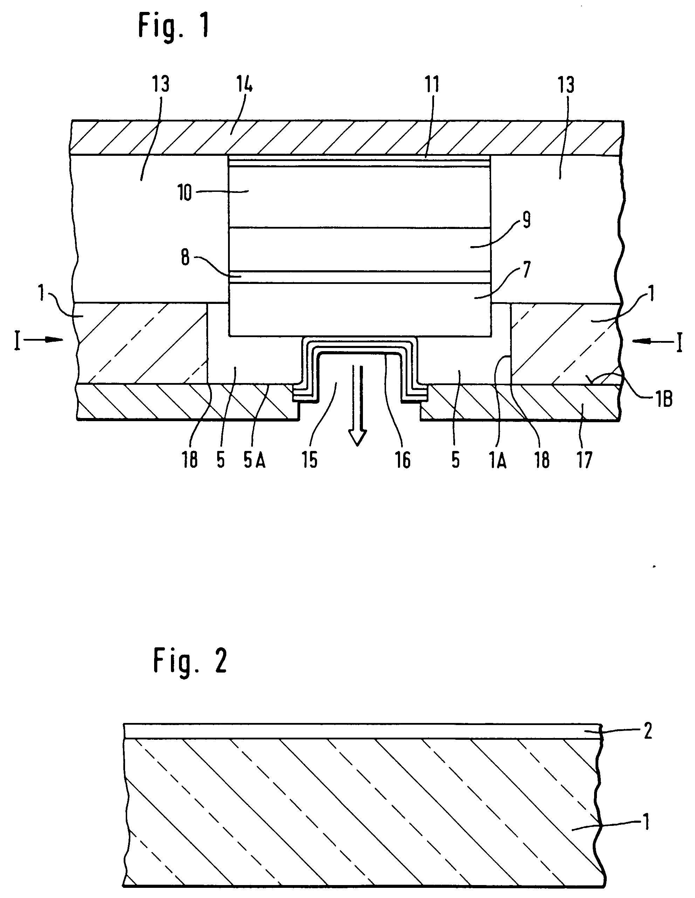

The following describes an embodiment of the present invention. Fig. 1 is a cross-sectional view illustrative of a semiconductor laser diode according to the embodiment.

In the drawing, a semiconductor laser diode comprises a sapphire substrate 1 having a hole lA; an n-GaN contact layer (hereinafter referred to as "n-type contact layer") 5 as a first contact layer is formed on a part in the hole lA of the sapphire substrate 1, and its exposed surface 5A provides a plane which continues from and which is nearly flush with an end side 18 of a main surface 1B of the substrate 1, so that it is nearly as thick as the sapphire substrate 1; an n-AlGaN cladding layer (n-type cladding layer) 7 as a first cladding layer; an undoped GaInN active layer (hereinafter referred to as "active layer") 8; a p-AlGaN cladding layer (hereinafter referred to as "p-type cladding layer") 9 as a second cladding layer; a p-GaN contact layer (p-type contact layer) 10 as a second contact layer; and a p-type semiconductor reflector 11 as a second reflector; is constituted AlN and AlGaN layers. The major section of the laser diode is composed of an epitaxial layer in which the n-type cladding layer 7, the active layer 8, the p-type cladding layer 9, the p-type contact layer 10, and the p-type semiconductor reflector 11 are deposited on the top surface of the n-type contact layer 5 in the order in which they are listed, the epitaxial layer being formed into a cylindrical shape. The double-hetero structure of AlGaN/GaInN is formed wherein the active layer 8 is placed between the n-type cladding layer 7 and the p-type cladding layer 9.

An insulating film 13 is formed on the sapphire substrate 1 to cover the whole side surface of the epitaxial layer from the n-type cladding layer 7 to the reflector 11, and functions to strangulate currents in a typical laser diode. A p-type ohmic electrode (hereinafter referred to as "p electrode") 14 is formed over the entire top surface of the insulating layer 13 so that it is brought in ohmic contact with the p-type contact layer 10 via the reflector 11. An opening 15 opens up to the n-AlGaN cladding layer 7. A reflector 16 as a first reflector is formed over the whole surface of the n-type cladding layer 7 in the opening 15, and is made of a dielectric film composed of a multilayer of ZrO and SiO2. An n-type ohmic electrode (hereinafter referred to as "n electrode") 17 is formed on the whole surface of the sapphire substrate 1 so that it is brought in ohmic contact with the n-type contact layer 5.

Voltage is applied to the p electrode 14 and the n electrode 17, and when the value of the current generated between the n-type contact layer 5 and the p-type contact layer 10 exceeds an oscillation threshold value, the light resonated by the reflectors 11 and 16 is emitted as a laser beam through the opening 15 in the direction of the arrow. Short-wavelength light, which ranges from ultraviolet to green, is generated by employing a GaN III-V group semiconductor as the light emitting material just as in the case of this embodiment.

Since an insulating material such as sapphire is used for the substrate for the GaN material, it is difficult to connect the electrode provided on the substrate to the contact layer in the conventional laser diode wherein the contact layer and the double-hetero structure layer are deposited on the substrate. According to this embodiment, however, the contact layer 5 which is exposed on the main surface lB side of the sapphire substrate 1 permits easy and secure connection between the exposed surface 5A and the electrode 17, thus ensuring good ohmic contact between the n electrode 17 and the n-type contact layer 5 shown in Fig. 1.

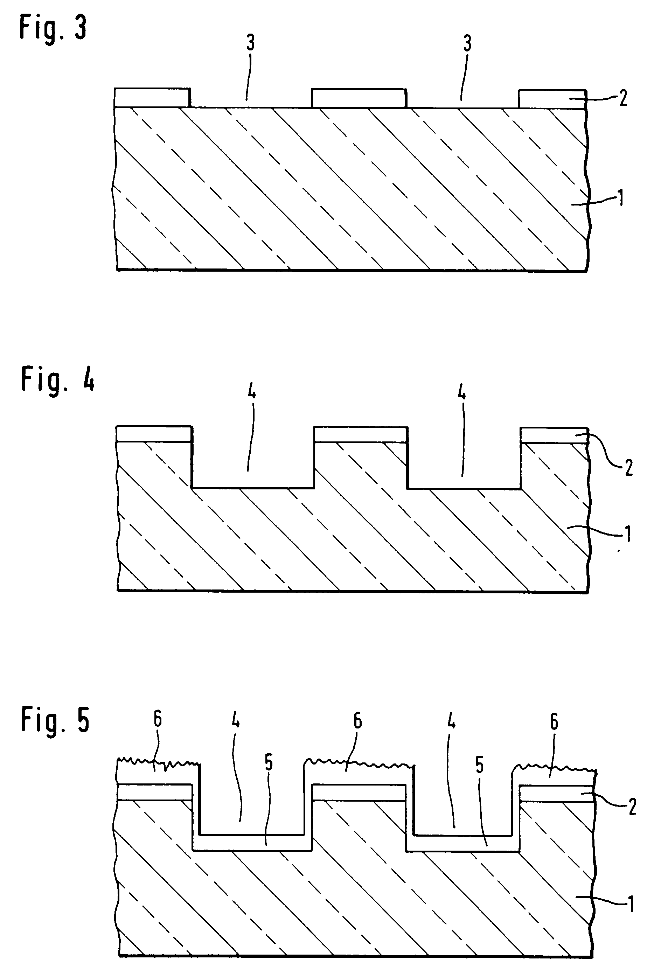

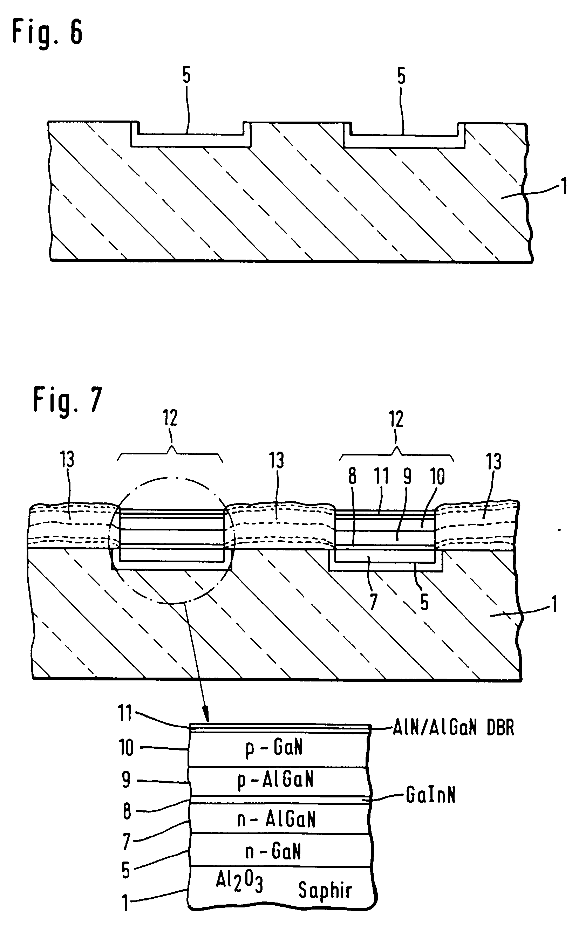

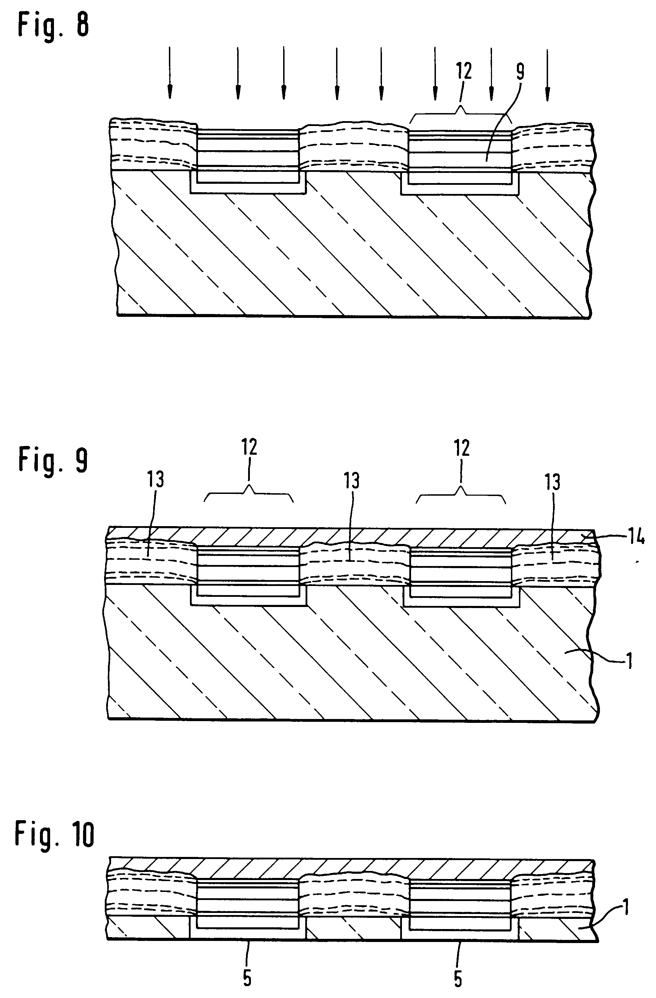

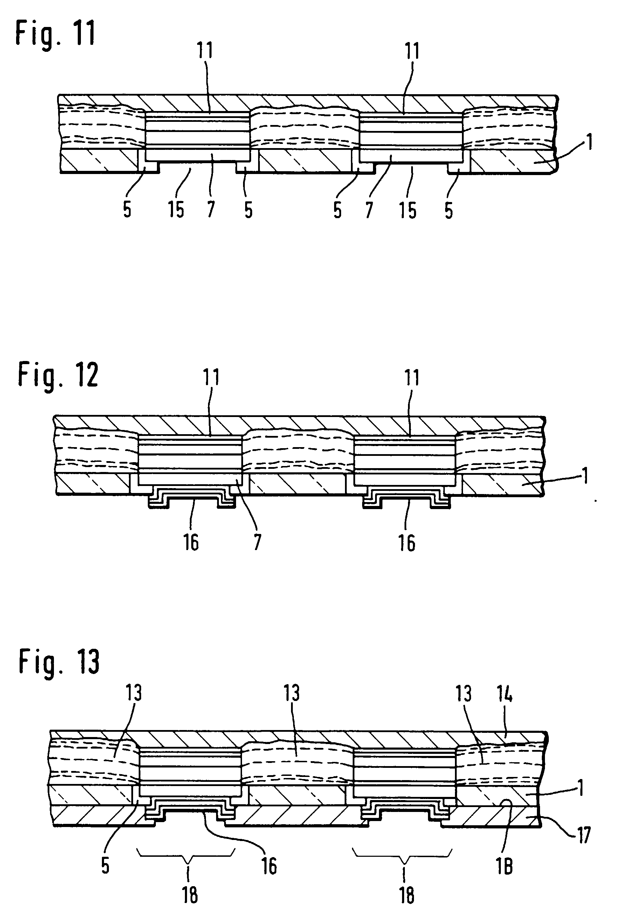

The manufacturing method for the semiconductor laser diode shown in Fig. 1 will now be described. Fig. 2 to Fig. 13 are cross-sectional views illustrative of the steps of the manufacturing process for the semiconductor laser diode.
(Step 1): First, as shown in Fig. 2, a protective film 2 is formed on the whole surface of the sapphire substrate 1. At this time, the sapphire substrate 1 measures 2 to 3 inches (1 inch = 2.54 cm) in diameter and 600 µm in thickness. The protective film 2 employs SiO2 and it is formed to have a thickness of 1000 Å (1 Å = 0.1 nm).
(Step 2): As shown in Fig. 3, the protective film 2 which provides a laser region (reference numeral 3) is selectively removed; it is removed, for example, in a circular area of 20 µm in diameter.
(Step 3): The exposed area of the sapphire substrate 1 is selectively etched. As shown in Fig. 4, an opening 4 which is approximately 10 µm deep is formed. Phosphoric acid to which sulfuric acid is added is heated to 200 degrees centigrade or above to produce the etchant for this purpose.
(Step 4): The n-type gallium nitride (GaN) is directly grown on the surface where the opening 4 has been formed as shown in Fig. 5. For growing the GaN crystal, the two-step growing technique based on the metal-organic chemical vapor deposition technique (MOCVD technique) is adopted. First, polycrystal GaN is grown at a substrate temperature ranging from 500 to 600 degrees centigrade, and then GaN is grown on its at a substrate temperature around 1000 degrees centigrade. This method grows quality single-crystal n-GaN 5 on the sapphire substrate in the openings 4 and polycrystal GaN 6 on the protective film 2 other than the openings. The polycrystal GaN 6 is an insulating layer with high resistance.
(Step 5): In Fig. 6, the surface of the sapphire substrate 1 is mechanically lapped to remove the polycrystal GaN layer 6 and the protective film 2 from the substrate so that shallow recessed portions from the openings remain on the single-crystal n-GaN layer 5 as shown in Fig. 6.
(Step 6): Then, the n-AlGaN layer 7, the undoped GaInN layer 8, the p-AlGaN layer 9, and the p-GaN layer 10 are deposited by epitaxy on the whole surface of the n- GaN layer 5 on the sapphire substrate 1 in the order in which they are listed at a substrate temperature of 800 to 1000 degrees centigrade, then an epitaxial layer composed of a multilayer structure 11 of AIN and AlGaN is formed on the p-GaN layer 10 by the same epitaxy. Thus, a single-crystal quality epitaxial layer 12 is formed right above the n-GaN 5 and a polycrystal high-resistance insulating layer 13 is formed on the sapphire substrate which has heen exposed by the lapping in Step 5 (Fig. 6). The double-hetero structure of AlGaN/GaInN is formed on the n-GaN layer 5, and also a distributed Bragg reflector (DBR) having a multilayer structure 11 is formed above it.
(Step 7): The surface of the epitaxial layer 12 is subjected to thermal annealing or electron beam irradiation until the p-AlGaN layer 9 is reached (Fig. 8), whereby a good p-type ohmic contact layer can be formed on the final surface.
(Step 8): The p-type electrode 14 is formed on the entire surfaces of the epitaxial layer 12 and the insulating layer 13 (Fig. 9).
(Step 9): In Fig. 10, the rear surface of the sapphire substrate 1 is mechanically lapped and then chemically etched until the n-GaN layer 5 is exposed (Fig. 10). Thus, the n-GaN layer 5 can be exposed without punching a hole in the sapphire substrate.
(Step 10): The n-GaN layer 5 is removed until the n-AlGaN layer 7 is exposed while leaving the peripheral area of the exposed n-GaN layer 5 which is connected to the sapphire substrate. As illustrated in Fig. 11, the opening 15 formed by the removal provides a window through which a laser beam is emitted. When the epitaxial layer extending from the n-type cladding layer 7 to the reflector 11, which provides the laser region, is cylindrically shaped, the n-GaN layer 5 is to be the n-type ohmic contact layer which is left in a donut shape. The opening is formed in the semiconductor layer, namely, the n-GaN layer 5, which allows an opening to be made easily, thus eliminating the need of making an opening in the difficult-to-process sapphire substrate. Hence, the window through which a laser beam is emitted can be formed easily.
(Step 11): The dielectric film 16 composed of a multilayer or the like of ZrO and SiO2 is produced over the whole surface of the n-AlGaN layer 7 which has been exposed through the opening 15 in Fig. 11 (Fig. 12). The dielectric film 16 provides the reflector which constitutes the resonator in combination with the reflector 11.
(Step 12): The dielectric film 16 is removed and the n electrode 17 is formed on the entire main surface of the sapphire substrate 1 so that it is brought in ohmic contact with the n-GaN layer 5 (Fig. 13). The n-GaN layer 5 is nearly flush with the substrate 1 to form a plane, allowing the n electrode 17 to be easily and securely connected to the n-GaN layer 5 on the plane. A laser diode device region 18 shown in Fig. 13 constitutes the device structure shown in Fig. 1 wherein the short-wavelength laser beams are oscillated.

The semiconductor laser diode having short-wavelength light which ranges from ultraviolet to green can be easily obtained with good reproducibility by the manufacturing process described above. The laser diode having short-wavelength light is expected to find a wide range of applications including animation, defense, and information communication.

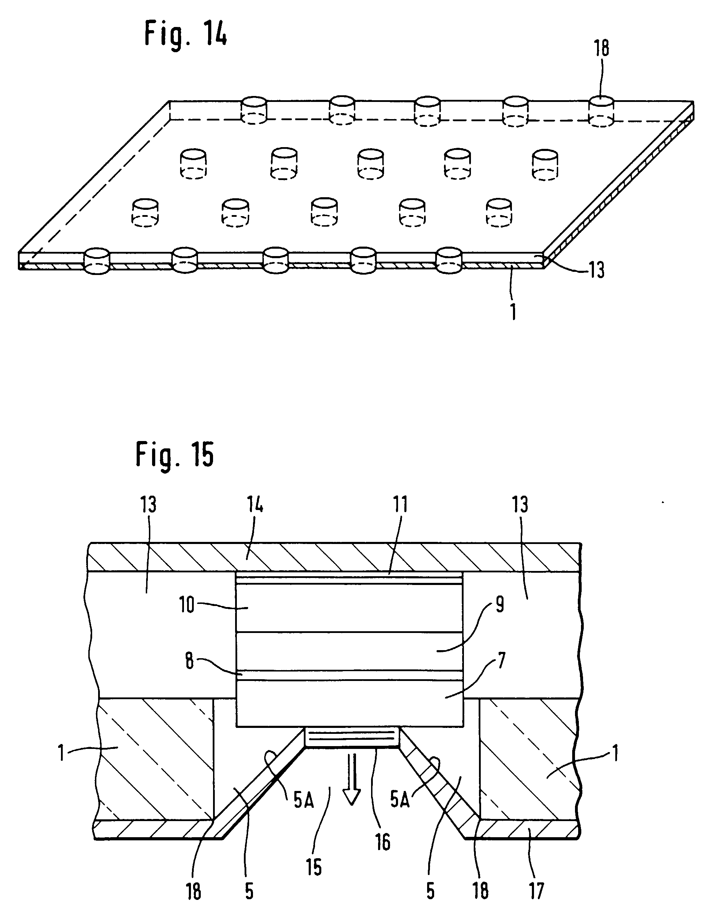

The manufacturing steps shown in Fig. 2 to Fig. 13 produce a plurality of discrete devices at a time. As illustrated in Fig. 14, an integrated laser diode is produced, wherein the laser diode device regions 18 of Fig. 1 are arranged two-dimensionally. Wiring the electrodes formed on the top and bottom surfaces of the integrated laser diode in a predetermined manner makes it possible to operate the plurality of laser structures independently or in a group of two or more, enabling monolithic integration to be achieved easily.

The integrated laser diode is constructed of a single chip which is to be mounted on a system. The use of the sapphire substrate ensures high mechanical strength to minimize the chance of damage during handling. The integrated laser diode also features good heat dissipation to permit easy dissipation of heat which is generated during laser operation. This prevents abnormal laser oscillation caused by heat generated.

In the semiconductor laser diode of Fig. 1, the laser region was formed into the cylindrical shape. It is not restricted, however, to the cylindrical shape; it may be formed into a square pole shape as long as it is placed above the n-type contact layer 5.

In the embodiment, sapphire is used for the substrate; however, other insulating material such as MgO and MgAl₂O₄ (spinel) may be used instead.

Likewise, in Step 9 (Fig. 10), the sapphire substrate 1 may be lapped until the n- GaN layer 5 and the sapphire substrate 1 become flush to form a plane. In Fig. 1, the bottom surface of the n-type cladding layer 7 is formed so that it becomes almost flush surface I - I with the surface of the sapphire substrate 1 and the exposed surface 5A of the n-GaN layer 5, whereby the exposed surface 5A in the n-GaN layer 5 is constructed by a surface composed of a plane which continues from an end side 18 of the main surface of the substrate 1 to the n-type cladding layer 7.

### Second Embodiment

Fig. 15 is a cross-sectional view showing the structure of a modification of the semiconductor laser diode of Fig. 1. The side surfaces of the opening 15 in the n-GaN layer 5 through which laser beams are emitted, are shaped so that they slant from the end sides 18 of the sapphire substrate to the n-AlGaN cladding layer 7. When the end sides 18 of the opening 15 are round, the surfaces are formed like a bowl, the reflector 16 being provided on the whole n-AlGaN cladding layer 7 which is the bottom thereof. Further, the n electrode contacts the n-GaN layer 5 through the whole side surfaces of the opening 15 via the end sides 18 from the sapphire substrate 1. The rest of the structure is the same as that of the semiconductor laser diode of Fig. 1, the materials used being also the same.

The manufacturing process for the semiconductor laser diode is the same as that for the first embodiment in Step 1 to Step 10. The side surfaces of the opening 15 shown in Fig. 11 are lapped so that the n-GaN layer 5 is furnished with a tapered continuous surface from the substrate 1 to the n-AlGaN layer 7. After that, the dielectric film reflector 16 is formed on the surface of the n-AlGaN layer 7 which has been exposed through the opening 15 and the n electrode is formed on the surfaces of the sapphire substrate 1 and the n-GaN layer 5.

The n-GaN contact layer 5 is formed as shown in Fig. 15; therefore, a large area of contact between the n electrode 17 and the n-GaN layer 5 is allowed, ensuring lower contact resistance. This permits good laser oscillation. Regarding the connection, the surface of the sapphire substrate 1 and the surface of the n-GaN layer 5 are so made that they are formed continuously via the end sides 18. Thus, there is no difficult steps in forming the electrodes, enabling the n electrode 17 to be connected to the n-GaN layer 5 easily and securely.

There is another modification although it is not shown. In the laser diode structure shown in Fig. 1, the surface of the n-GaN contact layer 5 may be projected or recessed from the surface of the sapphire substrate 1 so that the n-GaN layer 5 is furnished with a surface which continues from the surface of the sapphire substrate 1 with an end side 18 thereof being the boundary.

### Third Embodiment

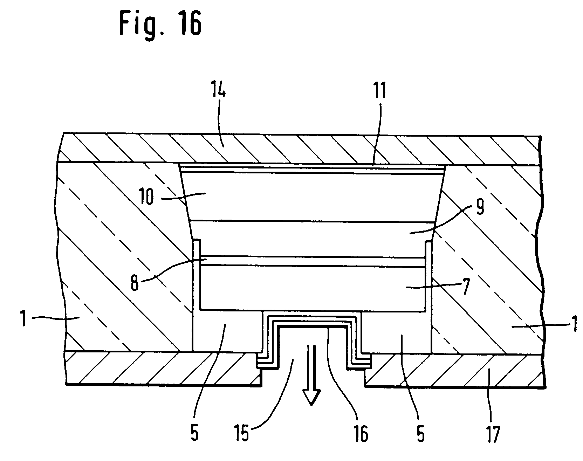

Fig. 16 is a cross-sectional view illustrative of the structure of the semiconductor laser diode according to this embodiment. In the drawing, the n-AlGaN cladding layer 7, the undoped GaN layer 8, the p-AlGaN cladding layer 9, the p-GaN contact layer 10, and the p-semiconductor reflector 11 are deposited on the n-GaN layer 5; all the side surfaces of the multilayer structure from the n-GaN layer 5 to the semiconductor reflector 11 are covered by the sapphire substrate 1. The side surfaces of the n-GaN contact layer 5 are covered from the n-AlGaN cladding layer 7 up to an arbitrary height of the p-AlGaN cladding layer 9. The rest of the structure is the same as that of the semiconductor laser diode of Fig. 1, the materials used being also the same.

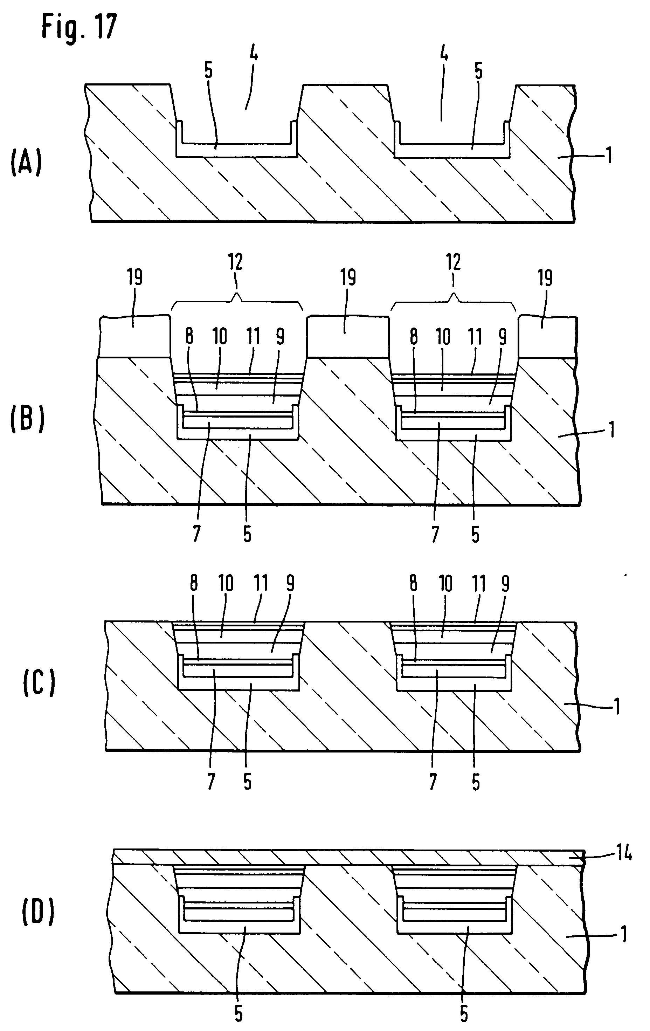

The manufacturing method for the semiconductor laser diode will now be described. Fig. 17 is a cross-sectional view illustrative of the manufacturing method. The manufacturing method is the same as that for the first embodiment in Step 1 (Fig. 2) to Step 5 (Fig. 6). The opening 4 in this embodiment, however, is cut deeper than the one shown in Fig. 4, and the protective film 2 is lapped.

As shown in Fig. 17 (A), the side surface of the opening 4 is lapped again from the top section thereof in order to remove the n-GaN layer 5. The n-GaN layer 5 on the side surface may be completely removed or it may be left out up to a predetermined height from the bottom of the opening 4.

In Fig. 17 (B), the epitaxial layer 12 is grown, wherein the n-AlGaN layer 7, the undoped GaInN layer 8, the p-AlGaN layer 9, the p-GaN layer 10, and the reflector 11 comprised of the multilayer of AIN and AlGaN, are buried and deposited in the recessed section in the order in which they are listed from the bottom of the recessed section. At this time, the use of the molecular beam epitaxial (MBE) technique makes it possible to form the epitaxial layer only on the n-GaN layer 5 and a polycrystal semiconductor layer 19 rather than the epitaxial layer on the sapphire substrate 1. The n-GaN layer 5 on the side surface of the opening 4 may be left to a height at which it does not contact the p-GaN layer 10; it may be left, for example, to the height at which the p-AlGaN layer 8 covers the n-GaN layer 5.

In Fig. 17 (C), the surface of the sapphire substrate 1 is mechanically lapped so that the reflector 11 becomes flush with the surface of the sapphire substrate 1. The polycrystal semiconductor layer 19 is completely removed.

After that, as shown in Fig. 17 (D), the p electrode 14 is formed on the entire surfaces of the epitaxial layer 12 and the sapphire substrate 1. The step of (D) corresponds to (Step 8) of the first embodiment; the subsequent manufacturing steps up to the step for forming the n electrode on the rear surface of the substrate are exactly the same as those of (Step 9) and after in the first embodiment. Thus, the device structure of the semiconductor laser diode as shown in Fig. 16 is obtained.

In the laser diode of Fig. 16, the side surfaces of the multilayer structure located between the n-GaN layer 5 and the p-type semiconductor reflector 11 are entirely covered with the sapphire substrate 1; the nonconductivity thereof is markedly greater than that of the insulating layer 13 constructed by the polycrystal semiconductor of Fig. 1. This means that the laser diode provides an extremely good strangulating function for preventing currents from occurring in other regions than the epitaxial layer 12 at the time of laser oscillation, thus permitting efficient, high-performance laser oscillation. In addition, the sapphire exhibits better heat dissipation compared with the insulating layer of the polycrystal semiconductor; therefore, the heat generated at the time of laser oscillation can be easily dissipated, making it possible to prevent an anomaly in laser oscillation caused by heat generated.

The same effect can be obtained by employing an insulating material such as MgO and MgAl₂O₄ (spinel) in place of sapphire.

The n-GaN contact layer 5 may be shaped like the laser diode of Fig. 15.

### Fourth Embodiment

Fig. 18 is a cross-sectional view illustrative of the structure of another semiconductor laser diode shown in this embodiment. The drawing shows a multilayer structure constructed by a sapphire substrate 31 having an opening 31A, an n-GaN buffer layer 32 or a first contact layer 32, an n-AlGaN cladding layer 33 as a first cladding layer, an undoped GaInN active layer 34, a p-AlGaAs cladding layer 35 as a second cladding layer, an n-GaN blocking layer 36, and a p-GaN contact layer 37 as a second contact layer which are deposited in the order in which they are listed. The region where a laser beam is oscillated, has a multilayer structure comprised of the n- AlGaN cladding layer 33, the undoped GaInN active layer 34, the p-AlGaN cladding layer 35, and the p-GaN contact layer 36; the dielectric film reflector 28 as a first reflector is provided on the surface of the n-AlGaN cladding layer 33 and the p-type semiconductor reflector 29 as a second reflector is provided on the surface of the p-GaN contact layer 37 in such a manner that the dielectric film reflector 28 and the p-type semiconductor reflector 29 face against each other, thereby making the resonator. Further provided are the nearly cylindrical opening 30 which exposes the dielectric film reflector 28 to the sapphire substrate 31, the n electrode on the main surface of the sapphire substrate 31, and the p electrode on the main surface of the p-GaN contact layer 37.

A contact hole 38 which runs from the main surface 31A of the sapphire substrate 31 to the n-GaN buffer layer 32 is formed.

An extension 40 of the n electrode 17 is inserted in the contact hole 38 to connect the n electrode 17 to the n-GaN buffer layer 32. Thus, voltage is applied to the n electrode 17 and the p electrode 14 so as to supply currents to the n-AlGaN cladding layer 33, the undoped GaInN active layer 34, the p-AlGaN cladding layer 35, and the p-GaN contact layer 36 which constitute the laser oscillation region, thereby enabling laser oscillation. Then, a short-wavelength laser beam is emitted through the opening 30.

Another application example is shown in the same drawing which illustrates the application example wherein the contact hole 38 of Fig. 18 is provided. In place of the contact hole 38, the surface exposed through the opening 30 may be utilized to make the electrical connection between the n-GaN buffer layer 32 and the n electrode; the n electrode 17 may be extended so that it is connected to the exposed surface of the n-GaN buffer layer 32 via the side wall 39 of the opening 30.

These embodiments of the invention having the above-described structure have the following advantages.
(1) In the semiconductor laser diode provided in the first aspect of the invention, the laser diode is equipped with the first contact layer of the first conductive type which is embedded in the substrate in such a manner that it has an exposed surface on the main surface side of the insulation substrate, thus allowing the electrode to be electrically connected to the aforesaid exposed surface. This enables laser oscillation and makes it possible to achieve the semiconductor laser diode which emits short-wavelength light.
(2) In the semiconductor laser diode provided in the second aspect of the invention, since the exposed surface in the first contact layer provides a plane which is continuous from and flush with the main surface of the substrate, the electrode on the substrate can be easily and securely connected to the first contact layer continuously from the end sides thereof. This makes it possible to obtain the high-performance semiconductor laser diode which emits short-wavelength light.
(3) In the semiconductor laser diode provided in the third aspect of the invention, since the exposed surface in the first contact layer is configured to provide a plane which continues from the end sides of the main surface of the substrate to the first cladding layer, the electrode on the substrate can be connected to the first contact layer continuously from the end sides thereof. This permits easy and secure connection, making it possible to obtain the high-performance semiconductor laser diode which emits short-wavelength light. In particular, a large area is allowed for the contact between the electrode and the first contact layer with consequent lower contact resistance.
(4) In the semiconductor laser diode provided in the 4th aspect of the invention, the side surfaces of the semiconductor layer which are perpendicular to the depositing direction are covered with the substrate; therefore, the currents can be strangulated in other regions than the semiconductor layer region, thus enabling the high-performance semiconductor laser diode to be achieved.
(5) In the semiconductor laser diode provided in the 5th aspect of the invention, the main surface of the substrate of the laser diode has a hole through which a part of the first contact layer is exposed and the electrode is connected to the first contact layer which is exposed through the hole; therefore, the electrode formed on the main surface of the substrate is electrically connected to the first contact layer. This enables laser oscillation and makes it possible to achieve the semiconductor laser diode which emits short-wavelength light.
(6) In the manufacturing method for semiconductor laser diode provided in the 6th aspect of the invention, the manufacturing method includes the step for burying the first semiconductor layer of the first conductive type in the hole formed in the main surface of the insulation substrate, and the step for lapping the rear surface of the substrate until the first semiconductor layer is exposed, thereby enabling the electrode to be connected to the first semiconductor layer to be formed on the rear surface of the substrate; it further includes a step for depositing the second semiconductor layer of the first conductive type which provides the cladding layer, the third semiconductor layer which provides the active layer, and the fourth semiconductor layer of the second conductive type, which provides the cladding layer on the first semiconductor layer, in the order in which they are listed, thereby connecting the electrode to the first cladding layer, thus enabling the high-performance semiconductor laser diode which emits short-wavelength light can be achieved.
(7) In the manufacturing method for semiconductor laser diode provided in the 7th aspect of the invention, the manufacturing method includes a step for growing an epitaxial layer on the substrate and the first semiconductor layer; therefore, the second, third, and fourth semiconductor layers can be formed on the first semiconductor layer and also the current strangulating layer covering the second, third, and fourth semiconductor layers, which provide the double-hetero structure, can be formed at the same time.
(8) In the manufacturing method for semiconductor laser diode provided in the 8th aspect of the invention, the manufacturing method includes for semiconductor laser diodes is designed to form the second, third, and fourth semiconductor layers in the hole wherein the first semiconductor layer is located; therefore, the current strangulating region can be obtained without the need of any extra step.

## Claims

1. A semiconductor laser diode comprising:
an insulation substrate (1) having a hole (1A);
a first contact layer (5) consisting of a first conductive type semiconductor, which is embedded in the hole (1A) of said substrate (1), so that said first contact layer (5) has an exposed surface (5A) on the side of a main surface (1B) of said substrate (1);
a semiconductor multilayer (7, 8, 9, 10) comprising a first cladding layer (7) consisting of the first conductive type semiconductor, an active layer (8), a second cladding layer (9) consisting of a second conductive type semiconductor, and a second contact layer (10) consisting of the second conductive type semiconductor, which are laminated in the order in which they are listed, said first cladding layer (7) being connected with said first contact layer (5), wherein said first contact layer (5) has an opening (15) so that said first cladding layer (7) is exposed on the side of the main surface (1B) of said substrate (1);
a first reflector (16) formed on the exposed surface of the first cladding layer (7) in said hole (15);
a second reflector (11) formed on the second contact layer (10) of said semiconductor multilayer (7, 8, 9, 10) so that said second reflector (11) faces against said first reflector (16); and
an electrode (17) which is formed on the main surface (1B) of said substrate (1) so that it is connected to the exposed surface (5A) of said first contact layer (5).

2. A semiconductor laser diode according to Claim 1, wherein said exposed surface (5A) in the first contact layer (5) provides a plane which continues from and which is nearly flush with an end side (18) of the main surface (1B) of said substrate (1).

3. A semiconductor laser diode according to Claim 1, wherein said exposed surface (5A) extends from an end side (18) of the main surface (1B) of said substrate (1) to said first cladding layer (7) and wherein said exposed surface (5A) of the first contact layer (5) lies in a plane which is inclined with respect to the main surface (1B) of the substrate (1).

4. A semiconductor laser diode according to any of the preceding Claims, wherein a side surface of said semiconductor layer (7, 8, 9, 10) is covered by said substrate (1).

5. A semiconductor laser diode comprising:
an insulation substrate (31) which has a hole (30) in a main surface (31A) thereof;
a first contact layer (32) consisting of a first conductive type semiconductor formed on said substrate (31);
a semiconductor multilayer (33, 34, 35, 36, 37) comprising a first cladding layer (33) consisting of the first conductive type semiconductor, an active layer (34), a second cladding layer (35) consisting of a second conductive type semiconductor, and a second contact layer (37) consisting of the second conductive type semiconductor, which are laminated in the order in which they are listed, wherein said first cladding layer (33), which forms the bottom surface of the hole (30) in said substrate (31), is connected with said first contact layer (32);
a first reflector (28) formed on said first cladding layer (33) which provides the bottom surface of said hole (30);
a second reflector (29) which is formed on said second contact layer (37) of said semiconductor multilayer (33, 34, 35, 36, 37) in such a manner the second reflector (29) faces against said first reflector (28); and
an electrode (17) formed on the main surface (31A) of said substrate (31); wherein
said electrode (17) and said first contact layer (32) formed on opposite sides of said insulation substrate (31) are connected with each other by electrical contact means (40; 41).

6. A semiconductor laser diode according to Claim 5, wherein said electrical contact means comprises an extension electrode (40) extending through a contact hole (38) which is formed in said substrate (31).

7. A semiconductor laser diode according to Claim 5 or 6, wherein said electrical contact means comprises an extension electrode (41) extending through said opening (30) of the substrate (31).

8. A semiconductor laser diode according to any of the preceding Claims, wherein said first and second contact layers (5, 10; 32, 37), said first and second cladding layers (7, 9; 33, 35), and said active layer (8; 34) are configured with a III-V group semiconductor having gallium nitride.

9. A semiconductor laser diode according to any of the preceding Claims, wherein said substrate (1; 31) is composed of sapphire.

10. A manufacturing method for a semiconductor laser diode comprising:
a first step of embedding a first semiconductor layer (5) consisting of a first conductive type in an opening (4) which is formed in a front surface of an insulation substrate (1);
a second step of laminating a second semiconductor layer consisting of the first conductivity type which provides a first cladding layer (7), a third semiconductor layer which provides an active layer (8), and a fourth semiconductor layer consisting of the second conductive type which provides a second cladding layer (9), in the order in which they are listed;
a third step of lapping a rear surface of said substrate (1) until said first semiconductor layer (5) is exposed; and
a fourth step of forming a hole (15), through which said second semiconductor layer (7) is exposed, in a surface of the first semiconductor layer (5) exposed on the rear surface of said substrate (31).

11. A manufacturing method according to Claim 10, wherein said second step includes a step of growing an epitaxial layer (12) on said substrate (1) and said first semiconductor layer (5).

12. A manufacturing method according to Claim 10, wherein said second step forms the second, third, and fourth semiconductor layers (7, 8, 9) in the hole (4) where the first semiconductor layer (5) has been embedded.

13. A manufacturing method according to any of Claims 10 to 12, wherein said first, second, third, and fourth semiconductor layers (5, 7, 8, 9, 10) are configured with a III-V group semiconductor having gallium nitride.

## Patentansprüche

1. Halbleiterlaserdiode, mit:
einem Isoliersubstrat (1), das ein Loch (1A) aufweist;
einer ersten Kontaktschicht (5), die aus einem Halbleiter eines ersten Leitfähigkeitstyps besteht, der in dem Loch (1A) des Substrats (1) eingebettet ist, so daß die erste Kontaktschicht (5) eine freiliegende Oberfläche (5A) auf der Seite der Hauptoberfläche (1B) des Substrats (1) besitzt;
einer Halbleitermehrfachschicht (7, 8, 9, 10) mit einer ersten Überzugsschicht (7), die aus dem Halbleiter vom ersten Leitfähigkeitstyp besteht, einer aktiven Schicht (8), einer zweiten Überzugsschicht (9), die aus einem Halbleiter eines zweiten Leitfähigkeitstyps besteht, und einer zweiten Kontaktschicht (10), die aus dem Halbleiter vom zweiten Leitfähigkeitstyp besteht, die in der Reihenfolge, in der sie aufgeführt sind, schichtweise aufeinander angeordnet sind, wobei die erste Überzugsschicht (7) mit der ersten Kontaktschicht (5) verbunden ist, worin die erste Kontaktschicht (5) eine Öffnung (15) besitzt, so daß die erste Überzugsschicht (7) auf der Seite der Hauptoberfläche (1B) des Substrats (1) freigelegt ist;
einem ersten Reflektor (16), der auf der freiliegenden Oberfläche der ersten Überzugsschicht (7) in dem Loch (15) ausgebildet ist;
einem zweiten Reflektor (11), der auf der zweiten Kontaktschicht (10) der Halbleitermehrfachschicht (7, 8, 9, 10) ausgebildet ist, so daß der zweite Reflektor (11) dem ersten Reflektor (16) gegenüberliegt; und
einer Elektrode (17), die auf der Hauptoberfläche (1B) des Substrats (1) ausgebildet ist, so daß sie mit der freiliegenden Oberfläche (5A) der ersten Kontaktschicht (5) verbunden ist.

2. Halbleiterlaserdiode nach Anspruch 1, worin die freiliegende Oberfläche (5A) in der ersten Kontaktschicht (5) eine Ebene bereitstellt, die sich von einer Endseite (18) der Hauptoberfläche (1B) des Substrats (1) fortsetzt und nahezu mit dieser fluchtet.

3. Halbleiterlaserdiode nach Anspruch 1, worin sich die freiliegende Oberfläche (5A) von einer Endseite (18) der Hauptoberfläche (1B) des Substrats (1) zur ersten Überzugsschicht (7) erstreckt und worin die freiliegende Oberfläche (5A) der ersten Kontaktschicht (5) in einer Ebene liegt, die bezüglich der Hauptoberfläche (1B) des Substrats (1) geneigt ist.

4. Halbleiterlaserdiode nach einem der vorhergehenden Ansprüche, worin eine Seitenoberfläche der Halbleiterschicht (7, 8, 9, 10) mit dem Substrat (1) bedeckt ist.

5. Halbleiterlaserdiode mit:
einem Isoliersubstrat (31), das ein Loch (30) in einer Hauptoberfläche (31A) davon aufweist;
einer auf dem Substrat (31) ausgebildeten ersten Kontaktschicht (32), die aus einem Halbleiter eines ersten Leitfähigkeitstyps besteht;
einer Halbleitermehrfachschicht (33, 34, 35, 36, 37) mit einer ersten Überzugsschicht (33), die aus dem Halbleiter des ersten Leitfähigkeitstyps besteht, einer aktiven Schicht (34), einer zweiten Überzugsschicht (35), die aus einem Halbleiter eines zweiten Leitfähigkeitstyps besteht, und einer zweiten Kontaktschicht (37), die aus dem Halbleiter des zweiten Leitfähigkeitstyps besteht, die in der Reihenfolge, in der sie aufgeführt sind, schichtweise aufeinander angeordnet sind, worin die erste Überzugsschicht (33), die die Bodenoberfläche des Lochs (30) in dem Substrat (31) bildet, mit der ersten Kontaktschicht (32) verbunden ist;
einem ersten Reflektor (28), der auf der ersten Überzugsschicht (33), die die Bodenoberfläche des Lochs (30) bereitstellt, ausgebildet ist;
einem zweiten Reflektor (29), der auf der zweiten Kontaktschicht (37) der Halbleitermehrfachschicht (33, 34, 35, 36, 37) in einer solchen Weise ausgebildet ist, daß der zweite Reflektor (29) dem ersten Reflektor (28) gegenüberliegt; und
einer Elektrode (17), die auf der Hauptoberfläche (31A) des Substrats (31) ausgebildet ist; worin
die Elektrode (17) und die erste Kontaktschicht (32), die auf gegenüberliegenden Seiten des Isoliersubstrats (31) ausgebildet sind, miteinander über eine elektrische Kontakteinrichtung (40; 41) verbunden sind.

6. Halbleiterlaserdiode nach Anspruch 5, worin die elektrische Kontakteinrichtung eine Fortsatzelektrode (40) umfaßt, die sich durch ein Kontaktloch (38), das in dem Substrat (31) ausgebildet ist, erstreckt.

7. Halbleiterlaserdiode nach Anspruch 5 oder 6, worin die elektrische Kontakteinrichtung eine Fortsatzelektrode (41) umfaßt, die sich durch die Öffnung (30) des Substrats (31) erstreckt.

8. Halbleiterlaserdiode nach einem der vorhergehenden Ansprüche, worin die ersten und zweiten Kontaktschichten (5, 10; 32, 37), die ersten und zweiten Überzugsschichten (7, 9; 33, 35) und die aktive Schicht (8; 34) mit einem Galliumnitrid aufweisenden Halbleiter der III-V-Gruppe aufgebaut sind.

9. Halbleiterlaserdiode nach einem der vorhergehenden Ansprüche, worin das Substrat (1; 31) aus Saphir besteht.

10. Herstellungsverfahren für eine Halbleiterlaserdiode mit:
einem ersten Schritt zum Einbetten einer ersten Halbleiterschicht (5), die aus einem ersten Leitfähigkeitstyp besteht, in einer Öffnung (4), die in einer Vorderoberfläche eines Isoliersubstrats (1) ausgebildet ist;
einem zweiten Schritt zum schichtweise Anordnen einer zweiten Halbleiterschicht, die aus dem ersten Leitfähigkeitstyp besteht und eine erste Überzugsschicht (7) bereitstellt, einer dritten Halbleiterschicht, die eine aktive Schicht (8) bereitstellt, und einer vierten Halbleiterschicht, die aus dem zweiten Leitfähigkeitstyp besteht und eine zweite Überzugsschicht (9) bereitstellt, in der Reihenfolge, in der sie aufgeführt sind;
einem dritten Schritt zum Läppen einer rückseitigen Oberfläche des Substrats (1), bis die erste Halbleiterschicht (5) freigelegt ist; und
einem vierten Schritt zum Bilden eines Lochs (15), durch das die zweite Halbleiterschicht (7) freigelegt wird, in einer auf der rückseitigen Oberfläche des Substrats (31) freigelegten Oberfläche der ersten Halbleiterschicht (5).

11. Herstellungsverfahren nach Anspruch 10, worin der zweite Schritt einen Schritt zum Aufwachsen einer Epitaxieschicht (12) auf dem Substrat (1) und der ersten Halbleiterschicht (5) einschließt.

12. Herstellungsverfahren nach Anspruch 10, worin der zweite Schritt die zweiten, dritten und vierten Halbleiterschichten (7, 8, 9) in dem Loch (4), in dem die erste Halbleiterschicht (5) eingebettet worden ist, ausbildet.

13. Herstellungsverfahren nach einem der Ansprüche 10 bis 12, worin die ersten, zweiten, dritten und vierten Halbleiterschichten (5, 7, 8, 9, 10) mit einem Galliumnitrid aufweisenden Halbleiter der III-V-Gruppe aufgebaut sind.

## Revendications

1. Diode laser à semi-conducteur comprenant :
un substrat isolant (1) ayant un trou (1A);
une première couche de contact (5) consistant en un semi-conducteur d'un premier type de conduction, qui est enfouie dans le trou (lA) dudit substrat (1), de sorte que ladite première couche de contact (5) a une surface exposée (5A) sur le côté d'une surface principale (1B) dudit substrat (1);
un multicouche semi-conducteur (7, 8, 9, 10) comprenant une première couche de placage (7) consistant du semi-conducteur du premier type de conduction, une couche active (8), une seconde couche de placage (9) consistant en un semi-conducteur d'un second type de conduction, et une seconde couche de contact (10) consistant du semi-conducteur du second type de conduction, qui sont laminés dans l'ordre dans lequel ils sont listés, ladite première couche de placage (7) étant reliée à ladite première couche de contact (5), où ladite première couche de contact (5) a une ouverture (15) de sorte que ladite première couche de placage (7) est exposée sur le côté de la surface principale (1B) dudit substrat (1);
un premier réflecteur (16) formé sur la surface exposée de la première couche de placage (7) dans ledit trou (15);
un second réflecteur (11) formé sur la seconde couche de contact (10) dudit multicouche semi-conducteur (7, 8, 9, 10) de sorte que ledit second réflecteur (11) fait face audit premier réflecteur (16); et
une électrode (17) qui est formée sur la surface principale (1B) dudit substrat (1) de sorte qu'elle est reliée à la surface exposée (5A) de ladite première couche de contact (5).

2. Diode laser à semi-conducteur selon la revendication 1, dans laquelle la surface exposée précitée (5A) dans la première couche de contact (5) fournit un plan qui continue à partir d'un côté d'extrémité (18) et qui est presque en affleurement avec celui-ci de la surface principale (1B) du substrat précité (1).

3. Diode laser à semi-conducteur selon la revendication 1, dans laquelle la surface exposée précitée (5A) s'étend d'un côté extrême (18) de la surface principale (1B) du substrat précité (1) vers la première couche de placage précitée (7) et dans laquelle ladite surface exposée (5A) de la première couche de contact (5) s'étend dans un plan qui est incliné par rapport à la surface principale (1B) du substrat (1).

4. Diode laser à semi-conducteur selon l'une quelconque des revendications précédentes, dans laquelle une surface latérale de la couche semi-conductrice précitée (7, 8, 9, 10) est couverte par le substrat précité (1).

5. Diode laser à semi-conducteur comprenant :
un substrat isolant (31) qui a un trou (30) dans une surface principale (31A) de celui-ci;
une première couche de contact (32) consistant en un semi-conducteur d'un premier type de conduction formé sur ledit substrat (31);
un multi-couche semi-conducteur (33, 34, 35, 36, 37) comprenant une première couche de placage (33) consistant du semi-conducteur du premier type de conductivité, une couche active (34), une seconde couche de placage (34) consistant d'un semi-conducteur d'un second type de conduction et une seconde couche de contact (37) consistant du semi-conducteur du second type de conduction, qui sont laminés dans l'ordre dans lequel ils sont listés, où la première couche de placage (33), qui forme la surface inférieure du trou (30) dans ledit substrat (31), est reliée avec ladite première couche de contact (32);
un premier réflecteur (28) formé sur ladite première couche de placage (33) qui réalise la surface inférieure dudit trou (30);
un second réflecteur (29) qui est formé sur ladite seconde couche de contact (37) dudit multi-couche semi-conducteur (33, 34, 35, 36, 37) de telle manière que le second réflecteur (29) fait face audit premier réflecteur (28); et
une électrode (17) formée sur la surface principale (31A) dudit substrat (31); où
ladite électrode (17) et ladite première couche de contact (32) formées sur les côtés opposés dudit substrat isolant (31) sont reliées l'une à l'autre par un moyen de contact électrique (40; 41).

6. Diode laser à semi-conducteur selon la revendication 5, dans laquelle le moyen de contact électrique précité comprend une électrode d'extension (40) s'étendant à travers un trou de contact (38) qui est formé dans le substrat précité (31).

7. Diode laser à semi-conducteur selon la revendication 5 ou 6, dans laquelle le moyen de contact électrique précité comprend une électrode d'extension (41) s'étendant à travers l'ouverture précitée (30) du substrat (31).

8. Diode laser à semi-conducteur selon l'une quelconque des revendications précédentes, dans laquelle les première et seconde couches de contact précitées (5, 10; 32, 37), les première et seconde couches de placage précitées (7, 9; 33, 35), et la couche active précitée (8; 34) sont configurées par un semi-conducteur de groupe III-V ayant du nitrure de gallium.

9. Diode laser à semi-conducteur selon l'une quelconque des revendications précédentes, dans laquelle le substrat précité (1; 31) est composé de sapphire.

10. Procédé de fabrication pour une diode laser à semi-conducteur comprenant :
une première étape d'enfouir une première couche semi-conductrice (5) consistant en un premier type de conduction dans une ouverture (4) qui est formée dans une surface frontale d'un substrat isolant (1);
une seconde étape de laminer une seconde couche semi-conductrice consistant du premier type de conductivité qui fournit une première couche de placage (7), une troisième couche semi-conductrice qui fournit une couche active (8), et une quatrième couche semi-conductrice consistant du second type de conduction qui fournit une seconde couche de placage (9), dans l'ordre dans lequel elles sont listées;
une troisième étape de recouvrir une surface arrière dudit substrat (1) jusqu'à ce que ladite première couche semi-conductrice (5) soit exposée; et
une quatrième étape de former un trou (15), à travers lequel ladite seconde couche semi-conductrice (7) est exposée, dans une surface de la première couche semi-conductrice (5) exposée sur la surface arrière dudit substrat (31).

11. Procédé de fabrication selon la revendication 10, dans lequel la seconde étape précitée comprend une étape de croître une couche épitaxiale (12) sur le substrat précité (1) et la première couche semi-conductrice précitée (5).

12. Procédé de fabrication selon la revendication 10, dans lequel la seconde étape précitée forme les seconde, troisième et quatrième couches semi-conductrices (7, 8, 9) dans le trou (4) où la première couche semi-conductrice (5) a été enfouie.

13. Procédé de fabrication selon l'une quelconque des revendications 10 à 12, dans lequel lesdites première, seconde, troisième et quatrième couches semi-conductrices (5, 7, 8, 9, 10) sont configurées par un semi-conducteur du groupe III-V ayant du nitrure de gallium.
